# EUROPEAN PATENT APPLICATION

(11) **EP 4 651 648 A1**
(43) Date of publication of application: **19.11.2025**
(21) Application number: 23932833.9
(22) Date of filing: 11.12.2023
(51) Int. Cl.: H05K 5/02

(54) **SHELL ASSEMBLY AND ELECTRONIC DEVICE**

(30) Priority: 11.04.2023 CN 202310431629
(71) Applicant: Honor Device Co., Ltd., Shenzhen, Guangdong 518040 (CN)
(72) Inventor: LV, Yan, Shenzhen, Guangdong 518040 (CN); YAN, Bin, Shenzhen, Guangdong 518040 (CN); ZHOU, Guotong, Shenzhen, Guangdong 518040 (CN); ZHAO, Yawei, Shenzhen, Guangdong 518040 (CN); LIU, Qichao, Shenzhen, Guangdong 518040 (CN)
(74) Representative: Thun, Clemens
(86) International application number: PCT/CN2023/137834
(87) International publication number: WO 2024/212562

(57) **Abstract**

This application provides a housing assembly and an electronic device. In the housing assembly, an engagement portion is arranged on a side of a middle frame facing a rear cover, so that the engagement portion avoids a bottleneck portion of the middle frame, and the engagement portion is recessed toward a side facing away from the rear cover. By using the engagement portion as a carrying basis of an adhesive layer, the adhesive layer between the middle frame and the rear cover passes through a region in which the engagement portion is located. In this way, the adhesive layer is carried by arranging the recessed engagement portion on the middle frame while the bottleneck portion of the middle frame is avoided to ensure a structural strength of the middle frame, so that the adhesive layer no longer occupies a thickness space of the electronic device alone, but the adhesive layer can be accommodated through at least a part of a wall thickness space of the middle frame. Therefore, a gap between the rear cover and the middle frame is reduced, and an entire thickness is reduced while a waterproof effect of the electronic device is ensured, which is conducive to the lightening and thinning development of the electronic device.

## Description

This application claims priority to Chinese Patent Application No. 202310431629.0, filed with the China National Intellectual Property Administration on April 11, 2023 and entitled "HOUSING ASSEMBLY AND ELECTRONIC DEVICE", which is incorporated herein by reference in its entirety.

### TECHNICAL FIELD

This application relates to the field of electronic devices, and in particular, to a housing assembly and an electronic device.

### BACKGROUND

With the development of science and technology, designs of electronic devices such as mobile phones and tablet computers are becoming thinner and lighter, to meet use requirements of consumers.

Using a mobile phone as an example, a battery cover of the electronic device is adhered to a middle frame through a back adhesive, and the middle frame, the back adhesive, and the battery cover jointly define a thickness of the mobile phone. As the entire electronic device is thinned, some structures on the middle frame have become a bottleneck in reducing the entire thickness, especially for a foldable mobile phone. The back adhesive covers parts on the middle frame corresponding to the structures. As a result, limited by sizes of the structures, the back adhesive occupies relatively large space between the middle frame and the battery cover, a gap between the battery cover and the middle frame cannot be further reduced, and the entire thickness of the electronic device cannot be reduced.

### SUMMARY

This application provides a housing assembly and an electronic device. An adhesive layer of the housing assembly avoids a bottleneck portion of a middle frame, so that an entire thickness may be reduced while a waterproof effect is ensured, which is conducive to lightening and thinning of the electronic device.

According to an aspect, this application provides a housing assembly, including:
a rear cover;
a middle frame, including an engagement portion on a side facing the rear cover, where the engagement portion avoids a bottleneck portion of the middle frame, and the engagement portion is recessed toward a side facing away from the rear cover relative to the bottleneck portion; and
an adhesive layer, arranged between the rear cover and the middle frame and passing through a region in which the engagement portion is located.

According to the housing assembly provided in this application, the engagement portion is arranged on the side of the middle frame facing the rear cover, so that the engagement portion avoids the bottleneck portion of the middle frame, and the engagement portion is recessed toward the side facing away from the rear cover. By using the engagement portion as a carrying basis of the adhesive layer, the adhesive layer between the middle frame and the rear cover passes through the region in which the engagement portion is located. In this way, the adhesive layer is carried by arranging the recessed engagement portion on the middle frame while the bottleneck portion of the middle frame is avoided to ensure a structural strength of the middle frame, so that the adhesive layer no longer occupies a thickness space of an electronic device alone, but the adhesive layer can be accommodated through at least a part of a wall thickness space of the middle frame. Therefore, a gap between the rear cover and the middle frame is reduced, and an entire thickness is reduced while a waterproof effect of the electronic device is ensured, which is conducive to the lightening and thinning development of the electronic device.

In a possible implementation, the bottleneck portion is located in an edge region of the middle frame, and the engagement portion is adjacent to a side of the bottleneck portion facing away from an edge of the middle frame.

The bottleneck portion of the middle frame is generally located in the edge region of the middle frame, and by arranging the engagement portion on the side of the bottleneck portion facing away from the edge of the middle frame, the engagement portion avoids the bottleneck portion. In addition, the engagement portion is adjacent to the bottleneck portion, so that the engagement portion is still maintained in a region close to the edge of the middle frame, and the adhesive layer connected to the engagement portion may connect the rear cover to the middle frame firmly, thereby ensuring a connection strength between the rear cover and the middle frame and a waterproof effect of the entire electronic device.

In a possible implementation, a side surface of the bottleneck portion facing the rear cover is a first positioning surface, a side surface of the engagement portion facing the rear cover is a second positioning surface, and a gap between the second positioning surface and the first positioning surface is greater than or equal to 1/2 of a thickness of the adhesive layer.

The gap between the first positioning surface of the engagement portion and the second positioning surface of the bottleneck portion is greater than or equal to 1/2 of the thickness of the adhesive layer, at least 1/2 of the thickness of the adhesive layer is located in a thickness space of a side frame portion of the middle frame, a part of the adhesive layer protruding from the side frame portion is less than 1/2 of the thickness of the adhesive layer, so that a gap between the rear cover and the side frame portion of the middle frame may be reduced to at least 1/2 of the thickness of the adhesive layer.

In a possible implementation, the middle frame includes a middle plate portion and a side frame portion, the side frame portion is arranged around a periphery of the middle plate portion, and the middle plate portion, the side frame portion, and the rear cover jointly define an accommodating cavity, where
both the engagement portion and the bottleneck portion are located on the side frame portion.

The rear cover is adhered to the side frame portion of the middle frame through the adhesive layer, and the engagement portion is arranged in a region on the side frame portion avoiding the bottleneck portion, so that the engagement portion is recessed in the bottleneck portion, and the adhesive layer is connected to the engagement portion. Therefore, the adhesive layer may reuse a space of the side frame portion in a thickness direction of the electronic device, and the adhesive layer at least partially occupies a wall thickness of the side frame portion, thereby reducing a thickness space of the electronic device occupied by the adhesive layer, reducing the gap between the rear cover and the side frame portion, and further reducing the entire thickness of the electronic device.

In a possible implementation, in a thickness direction of the middle frame, the wall thickness of the bottleneck portion is greater than or equal to a preset thickness. That is, a region in which the bottleneck portion is located has a thickness requirement, and the wall thickness of the bottleneck portion should not be less than the preset thickness. The preset thickness may be a minimum thickness meeting a design requirement, to ensure a sufficient strength of the region in which the bottleneck portion is located, thereby ensuring the reliability of the side frame portion.

In a possible implementation, the housing assembly includes a first housing and a second housing, and both the first housing and the second housing include the rear cover, the middle frame, and the adhesive layer; and
the housing assembly further includes:
a rotating shaft, connected between the middle frame of the first housing and the middle frame of the second housing, where both the engagement portion and the bottleneck portion are located in a region of the side frame portion corresponding to the rotating shaft.

In a possible implementation, the side frame portion includes a side wall and an extending wall sequentially connected to the middle plate portion, the side wall extends to the rear cover, and the extending wall extends to an edge of the rear cover in a plane direction of the rear cover, where
the extending wall includes the engagement portion and the bottleneck portion.

In a possible implementation, the side frame portion is provided with an insertion hole, an interface device is mounted in the insertion hole, and the interface device is configured to connect to an external device, where
a side hole wall of the insertion hole facing the rear cover includes the bottleneck portion and the engagement portion.

In a possible implementation, the interface device includes a device body, the device body includes a power connection end and an insertion end sequentially connected in a direction from the accommodating cavity to the insertion hole, the power connection end is connected to a circuit board arranged in the accommodating cavity, and the insertion end is configured to connect to the external device, where
the bottleneck portion corresponds to a region in which the insertion end is located; and the engagement portion corresponds to a region in which a connection portion between the insertion end and the power connection end is located, or the engagement portion corresponds to a region in which the power connection end is located.

In the side hole wall of the insertion hole facing the rear cover, a portion corresponding to the region in which the insertion end of the device body is located is the bottleneck portion, and the engagement portion is correspondingly arranged in the region in which the connection portion between the insertion end and the power connection end of the device body is located, or the engagement portion is arranged in the region in which the power connection end of the device body is located, to enable the engagement portion to avoid the bottleneck portion.

In a possible implementation, an insertion cavity is defined between an outer wall surface of the insertion end and a hole wall of the insertion hole, and the insertion cavity is configured for insertion of the external device.

By directly arranging the device body in the insertion hole, an outer frame arranged around an outer periphery of the device body is canceled, so that the outer wall surface of the insertion end of the device body and the hole wall of the insertion hole directly define the insertion cavity without expanding an opening size of the insertion hole. Therefore, there is no need to increase a thickness of the side frame portion, which is conducive to reducing the entire thickness of the electronic device.

In a possible implementation, a sealing member is arranged on an outer wall surface of the device body, and the sealing member is in close contact with the hole wall of the insertion hole.

By arranging the sealing member on the outer wall surface of the device body, the sealing member is in close contact with the hole wall of the insertion hole, the sealing member is used to seal a seam between the device body and the insertion hole, to prevent external foreign objects such as moisture or dust from entering the accommodating cavity from the seam between the insertion hole and the device body, thereby ensuring a waterproof effect of the entire electronic device.

In a possible implementation, the hole wall of the insertion hole protrudes inward to form a positioning boss, and the sealing member is in close contact with the positioning boss.

By arranging the positioning boss protruding inward on the hole wall of the insertion hole, the positioning boss is used to reduce a gap between the insertion hole at the portion and the device body, and it is ensured that the positioning boss may be in close contact with the sealing member and squeeze the sealing member, thereby further ensuring a sealing effect of the sealing member.

In a possible implementation, the positioning boss is located in the region in which the engagement portion is located.

By arranging the positioning boss in the region in which the engagement portion is located, it may be ensured that the positioning boss avoids the bottleneck portion of the insertion hole, and a thickness of the region in which the engagement portion is located may also be increased, thereby increasing a structural strength of the region in which the engagement portion is located.

In a possible implementation, the interface device further includes a fixing frame, the fixing frame is sleeved on the device body, and the fixing frame is connected to the circuit board.

The fixing frame is sleeved outside the device body and the fixing frame is connected to the circuit board, to position the device body, thereby ensuring a firm connection between the power connection end of the device body and the circuit board.

In a possible implementation, the adhesive layer includes a recessed segment protruding toward the accommodating cavity at a portion in which the insertion hole is located.

The bottleneck portion of the insertion hole extends inward from an outer edge of the side frame portion, and the engagement portion is located on a side of the side frame portion close to the accommodating cavity, so that the adhesive layer forms the recessed segment at the portion in which the insertion hole is located, and the recessed segment is recessed inward from the outer edge of the side frame portion. That is, the recessed segment protrudes toward the accommodating cavity.

In a possible implementation, the adhesive layer is a solid thin film layer or a liquid curing surface.

According to another aspect, this application provides an electronic device, including a display screen and the housing assembly described above, where the display screen is connected to the housing assembly.

The electronic device provided in this application includes the display screen and the housing assembly, and the display screen is supported and fixed on the housing assembly. In the housing assembly, the engagement portion is arranged on the side of the middle frame facing the rear cover, so that the engagement portion avoids the bottleneck portion of the middle frame, and the engagement portion is recessed toward the side facing away from the rear cover. By using the engagement portion as a carrying basis of the adhesive layer, the adhesive layer between the middle frame and the rear cover passes through the region in which the engagement portion is located. In this way, the adhesive layer is carried by arranging the recessed engagement portion on the middle frame while the bottleneck portion of the middle frame is avoided to ensure a structural strength of the middle frame, so that the adhesive layer no longer occupies a thickness space of an electronic device alone, but the adhesive layer can be accommodated through at least a part of a wall thickness space of the middle frame. Therefore, a gap between the rear cover and the middle frame is reduced, and an entire thickness is reduced while a waterproof effect of the electronic device is ensured, which is conducive to the lightening and thinning development of the electronic device.

### BRIEF DESCRIPTION OF DRAWINGS

FIG. 1 is a schematic structural diagram of an electronic device according to an embodiment of this application;
FIG. 2 is an exploded structural view of the electronic device shown in FIG. 1;
FIG. 3 is a schematic structural diagram of another electronic device in an unfolded state according to an embodiment of this application;
FIG. 4 is a schematic structural diagram of the electronic device in FIG. 3 in a folded state;
FIG. 5 is a schematic structural diagram of the electronic device in FIG. 3 in a semi-unfolded state;
FIG. 6 is an exploded structural view of the electronic device in FIG. 3;
FIG. 7 is a partial structural diagram of a housing assembly in the related art;
FIG. 8 is a cross-sectional view of the housing assembly in FIG. 7 along A-A;
FIG. 9 is a partial structural diagram of a housing assembly according to an embodiment of this application;
FIG. 10 is a cross-sectional view of the housing assembly in FIG. 9 along B-B;
FIG. 11 is a partial enlarged view of the housing assembly in FIG. 10 at a position A;
FIG. 12 is a schematic structural diagram of the housing assembly in FIG. 9 with a rear cover removed;
FIG. 13 is an exploded structural view of the housing assembly in FIG. 12;
FIG. 14 is a partial structural diagram of another housing assembly according to an embodiment of this application; and
FIG. 15 is a cross-sectional view of the housing assembly in FIG. 14 along C-C.

### DESCRIPTION OF EMBODIMENTS

Terms used in implementations of this application are merely intended to explain specific embodiments of this application rather than being intended to limit this application.

An embodiment of this application provides an electronic device, and the electronic device may be an electronic product of a consumption type. For example, the electronic device includes but is not limited to a mobile phone, a portable android device (portable android device, PAD), a notebook computer (NoteBook Computer, referred to as NoteBook for short), an ultra-mobile personal computer (ultra-mobile personal computer, UMPC), a walkietalkie, a netbook, a POS (Point of sales) machine, a personal digital assistant (personal digital assistant, PDA), a wearable device, a virtual reality (virtual reality, VR) device, or an augmented reality (augmented reality, AR) device.

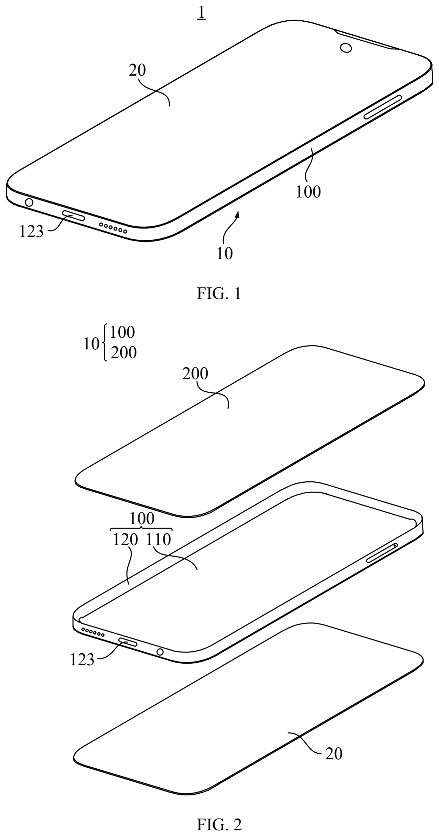

FIG. 1 is a schematic structural diagram of an electronic device according to an embodiment of this application. As shown in FIG. 1, an example in which the electronic device 1 is a straight plate electronic device is used, for example, the electronic device 1 is a straight plate mobile phone, and the electronic device 1 may include a housing assembly 10 and a display screen 20. A side surface of the display screen 20 is configured to display image information, where the side surface of the display screen 20 is generally defined as a front surface of the display screen, and another side surface opposite to the front surface is defined as a back surface of the display screen. The housing assembly 10 is arranged around a periphery and the back surface of the display screen 20 and is configured to support and fix the display screen 20 and provide protection. The front surface of the display screen 20 is exposed outside the housing assembly 10, for a user to watch content displayed by the display screen 20 or perform an input operation on the electronic device 1.

Using the straight plate electronic device shown in the figure as an example, the display screen 20 of the electronic device 1 may be a rigid screen, and the display screen 20 may be an LCD (Liquid Crystal Display, liquid crystal display) display screen 20 or an OLED (Organic Light-Emitting Diode, organic light-emitting diode) display screen 20.

FIG. 2 is an exploded structural view of the electronic device shown in FIG. 1. As shown in FIG. 2, the straight plate electronic device is used as an example, the housing assembly 10 of the electronic device 1 includes a middle frame 100 and a rear cover 200, where the middle frame 100 is connected between the display screen 20 and the rear cover 200, the display screen 20 is supported on a side surface of the middle frame 100, and the rear cover 200 is connected to another side surface of the middle frame 100. The display screen 20 is generally supported on the middle frame 100 as a whole, to ensure a strength and reliability of the display screen 20 and meet a use requirement of the display screen 20. The rear cover 200 is generally connected to the middle frame 100 in a bridging manner, the middle frame 100 and the rear cover 200 jointly define an accommodating cavity, and the accommodating cavity is configured to mount devices such as a circuit board (not shown in the figure), a battery (not shown in the figure), an interface device (not shown in the figure), a camera module (not shown in the figure), or a microphone (not shown in the figure).

The middle frame 100 may include a middle plate portion 110 and a side frame portion 120, where the middle plate portion 110 is located between the display screen 20 and the rear cover 200 and is generally arranged parallel to the display screen 20 and the rear cover 200, the side frame portion 120 is arranged around a periphery of the middle plate portion 110, and the side frame portion 120 may extend, for example, toward two sides of the middle plate portion 110 in a direction perpendicular to a plate surface of the middle plate portion 110. For example, the side frame portion 120 and the middle plate portion 110 may be an integrally formed structure.

The display screen 20 is generally attached to the middle plate portion 110 of the middle frame 100 as a whole. For example, the display screen 20 is adhered to the middle plate portion 110 as a whole, and a stable and firm support to the display screen 20 may be ensured by depending on a support of the middle plate portion 110 to the display screen 20, so that the display screen 20 has a sufficient strength, thereby meeting a use requirement of being frequently pressed of the display screen 20. The side frame portion 120 is arranged around the periphery of the display screen 20 to protect an edge of the display screen 20, to assist the display screen 20 in resisting risk scenarios such as collision and falling off, so as to protect the display screen 20 from being damaged.

An edge of the rear cover 200 is connected to the side frame portion 120 of the middle frame 100. For example, the edge of the rear cover 200 is adhered to the side frame portion 120. A gap exists between the middle plate portion 110 of the middle frame 100 and the rear cover 200, and the gap forms the accommodating cavity described above, so that devices are mounted in the accommodating cavity between the middle plate portion 110 of the middle frame 100 and the rear cover 200. For example, the rear cover 200 may be approximately in a shape of a plate, the edge of the rear cover 200 may be bridged to the side frame portion 120 of the middle frame 100, and the entire rear cover 200 is located in a region defined by the side frame portion 120; or the rear cover 200 is designed with a flange bent toward the middle frame 100, and the flange is arranged around an outer side of the side frame portion 120 of the middle frame 100, to wrap the middle frame 100 in the rear cover.

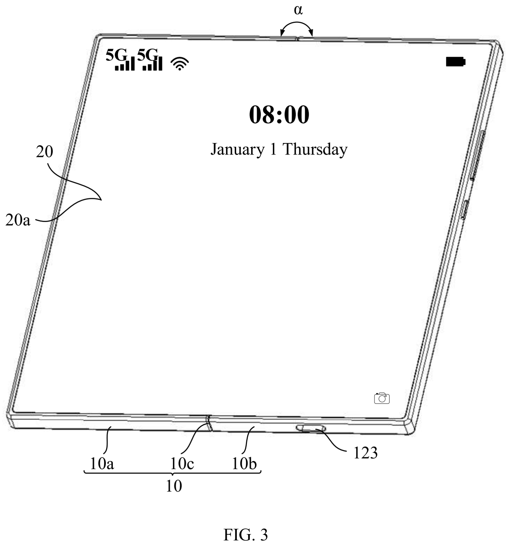

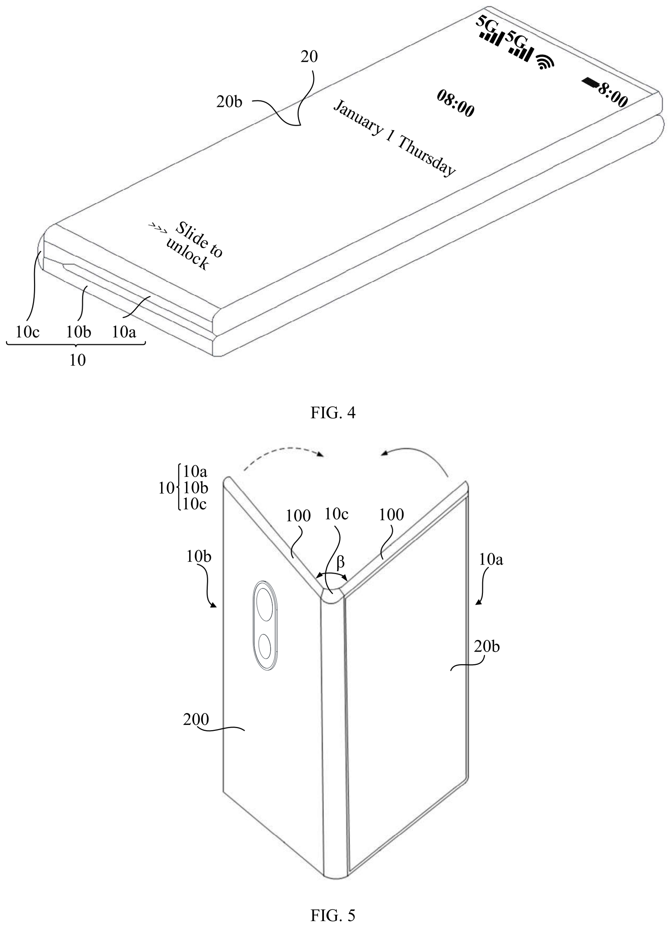

FIG. 3 is a schematic structural diagram of another electronic device in an unfolded state according to an embodiment of this application; FIG. 4 is a schematic structural diagram of the electronic device in FIG. 3 in a folded state; and FIG. 5 is a schematic structural diagram of the electronic device in FIG. 3 in a semi-unfolded state.

Referring to FIG. 3 to FIG. 5, an example in which the electronic device 1 is a foldable electronic device is used, for example, the electronic device 1 is a foldable mobile phone, and the electronic device 1 may include different use states in different use scenarios. FIG. 3 shows the electronic device 1 in an unfolded state, and an unfolding angle α of the electronic device 1 is, for example, 180 degrees. In this case, the electronic device 1 may implement large-screen display. FIG. 4 shows the electronic device 1 in a folded state. In this case, the electronic device 1 is small in size and is easy to carry. FIG. 5 shows the electronic device 1 in a semi-unfolded state. In this case, the electronic device 1 stays at an angle between the unfolded state and the folded state. For example, a staying angle β of the electronic device 1 may be 120 degrees, 130 degrees, 140 degrees, or 150 degrees.

It should be noted that, a slight deviation is allowed for all angles described by using examples in this embodiment. For example, that the unfolding angle α of the electronic device 1 is 180 degrees means that the unfolding angle α may be 180 degrees, or may be approximately 180 degrees, for example, 170 degrees, 175 degrees, 185 degrees, or 190 degrees. An angle described by using an example in the following may be understood in the same way.

In addition, it should be understood that, the electronic device 1 shown in FIG. 3 to FIG. 5 is an electronic device 1 that may be folded once, and the electronic device 1 includes two parts that can rotate relative to each other. When the two parts rotate to be coplanar, the electronic device 1 is in the unfolded state (as shown in FIG. 3); when the two parts rotate to overlap with each other, the electronic device 1 is in the folded state (as shown in FIG. 4); and when the two parts rotate to stay at an angle between the unfolded state and the folded state, the electronic device 1 is in the semi-unfolded state (as shown in FIG. 5). In another implementation, the electronic device 1 may alternatively be an electronic device 1 that may be folded a plurality of times (twice or more times). In this case, the electronic device 1 may include a plurality of parts rotatably connected to each other sequentially, where two adjacent parts may be away from each other to be unfolded to the unfolded state, or two adjacent parts may be close to each other to be folded to the folded state.

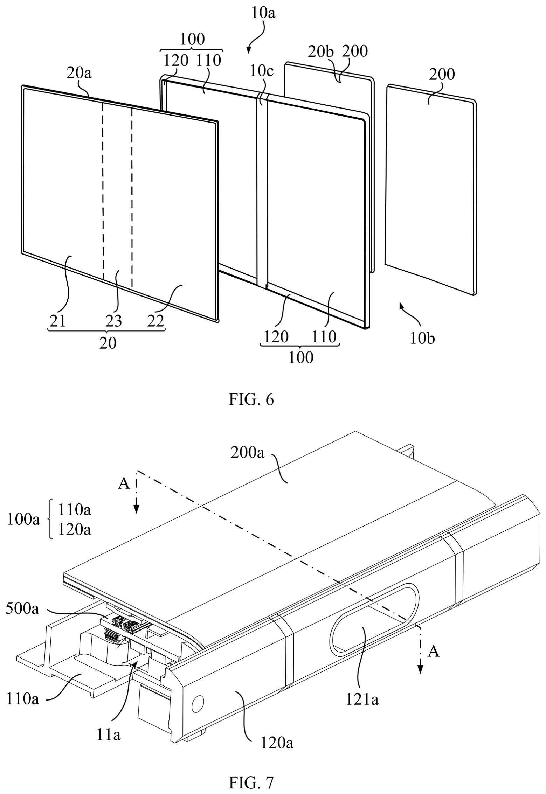

FIG. 6 is an exploded structural view of the electronic device in FIG. 3. Referring to FIG. 6, for a foldable electronic device, the electronic device 1 may also include a display screen 20 and a housing assembly 10, where a front surface of the display screen 20 is configured to display image information, and the housing assembly 10 is arranged around a periphery and a back surface of the display screen 20 and is configured to support and fix the display screen 20 and provide protection. Details are not described herein again.

The display screen 20 of the foldable electronic device may include a first region 21, a second region 22, and a bendable region 23, where the bendable region 23 is located between the first region 21 and the second region 22. During use of the electronic device 1, the first region 21 and the second region 22 always remain a plane state, and the bendable region 23 may be bent, to change an angle between the first region 21 and the second region 22, so that the foldable screen is folded or unfolded as the housing assembly 10 moves, thereby implementing switching of the electronic device 1 between the folded state and the unfolded state.

For example, in the display screen 20 of the foldable electronic device, at least the bendable region 23 is made of a flexible material, so that the bendable region 23 is bendable. The first region 21 and the second region 22 may be made of a flexible material or may be made of a rigid material, or may be partially made of a rigid material and partially made of a flexible material, which is not limited in this embodiment.

The display screen 20 of the foldable electronic device may be but not limited to an organic light-emitting diode (organic light-emitting diode, OLED) display screen 20, an active-matrix organic light-emitting diode (active-matrix organic light-emitting diode, AMOLED) display screen 20, a mini light-emitting diode (mini organic light-emitting diode) display screen 20, a micro light-emitting diode (micro organic light-emitting diode) display screen 20, a micro organic light-emitting diode (micro organic light-emitting diode) display screen 20, or a quantum dot light-emitting diode (quantum dot light-emitting diode, QLED) display screen 20.

As shown in FIG. 3 and FIG. 6, when the display screen 20 is in the unfolded state, the first region 21 and the second region 22 are in an unfolded state of being away from each other, and the bendable region 23 is in a flattened state without bending, where the first region 21, the second region 22, and the bendable region 23 have a same orientation and are in a coplanar state. in this case, the angle between the first region 21 and the second region 22 is 180 degrees, and the display screen 20 can implement large-screen display, which can provide more abundant information for a user and bring better use experience to the user. As shown in FIG. 4 and FIG. 6, when the display screen 20 is in the folded state, the first region 21 and the second region 22 overlap with each other, and the bendable region 23 is in a bent state, where a bending angle of the bendable region 23 is, for example, 180 degrees. In this case, the foldable electronic device 1 is small in size and is easy to carry and accommodate.

It should be noted that, an example in which the foldable electronic device is an inner foldable architecture is used in the figures, and when the electronic device 1 is in the folded state, the first region 21 and the second region 22 of the display screen 20 are attached to each other, and the housing assembly 10 is arranged around the outside the display screen 20, so that the display screen 20 may be prevented from being scratched by a hard object. Referring to FIG. 4, if the inner foldable electronic device needs to implement a display function in the folded state, a display screen 20 may be added to a back surface of the housing assembly 10, so that the foldable electronic device 1 implements the display function in the folded state by depending on the display screen 20. In other words, the display screen 20 of the inner foldable electronic device may include a first display screen 20a and a second display screen 20b, where the first display screen 20a may be a foldable screen mounted on a front surface of the housing assembly 10 and the first display screen 20a may be switched between an unfolded state and a folded state, and the second display screen 20b may be a single screen mounted on the back surface of the housing assembly 10 and the second display screen 20b may implement display when the electronic device 1 is in the folded state.

In another example, the foldable electronic device may alternatively be an outer foldable architecture, and when the electronic device 1 is in the folded state, the first region 21 and the second region 22 of the display screen 20 are opposite to each other, the housing assembly 10 is located between the first region 21 and the second region 22, and the display screen 20 is arranged around the outside of the housing assembly 10, so that the display screen 20 is exposed outside and visible to the user, and the display function may be implemented by using the display screen 20. Therefore, there is no need to additionally add a display screen 20 to the back surface of the housing assembly 10. In other words, the outer foldable electronic device may only include the display screen 20 mounted on the front surface of the housing assembly 10.

In addition, as shown in FIG. 5 and FIG. 6, in some implementations, especially when the foldable electronic device is an inner foldable electronic device, the electronic device 1 may stay at an angle between the unfolded state and the folded state by depending on a damping force provided by the housing assembly 10. For example, a staying angle of the electronic device 1 may be 120 degrees, 130 degrees, 140 degrees, or 150 degrees. In this case, the bendable region 23 of the display screen 20 is also in a bent state, the first region 21 and the second region 22 of the display screen 20 are inclined relative to each other, and the angle between the first region 21 and the second region 22 is, for example, 120 degrees, 130 degrees, 140 degrees, or 150 degrees.

For the foldable electronic device, in addition to supporting and fixing the display screen 20, the housing assembly 10 further needs to drive the display screen 20 to switch between the folded state and the unfolded state. Based on this, referring to FIG. 6, the housing assembly 10 of the foldable electronic device may include a first housing 10a, a second housing 10b, and a rotating shaft 10c, where the rotating shaft 10c is connected between the first housing 10a and the second housing 10b, and the first housing 10a and the second housing 10b are rotatably connected through the rotating shaft 10c to implement relative rotation between the first housing 10a and the second housing 10b.

The first housing 10a supports and fixes the first region 21 of the display screen 20, and the second housing 10b supports and fixes the second region 22 of the display screen 20. In other words, the first region 21 of the display screen 20 is fixedly connected to the first housing 10a, the second region 22 of the display screen 20 is fixedly connected to the second housing 10b, and the bendable region 23 of the display screen 20 is arranged corresponding to the rotating shaft 10c. When the rotating shaft 10c drives the first housing 10a and the second housing 10b to rotate relative to each other, orientations of the first region 21 and the second region 22 of the display screen 20 change accordingly, and the bendable region 23 of the display screen 20 is bent or flattened along with orientation changes of the first region 21 and the second region 22.

The rotating shaft 10c drives the first housing 10a and the second housing 10b to rotate relative to each other, to cause the electronic device 1 to switch between the folded state and the unfolded state. The first housing 10a and the second housing 10b may rotate in a direction away from each other to be coplanar. In this case, the housing assembly 10 is in the unfolded state, and the display screen 20 is in the unfolded state along with unfolding of the housing assembly 10, as shown in FIG. 3. The first housing 10a and the second housing 10b may alternatively rotate in a direction close to each other to overlap with each other. In this case, the housing assembly 10 is in the folded state, and the display screen 20 is in the folded state along with folding of the housing assembly 10, as shown in FIG. 4. The first housing 10a and the second housing 10b may alternatively rotate relative to each other until the two housings stay between the folded state and the unfolded state. In this case, the housing assembly 10 is in a semi-unfolded state (stay state), an angle between the first housing 10a and the second housing 10b200 is, for example, 120 degrees, 130 degrees, 140 degrees, or 150 degrees, and the display screen 20 is in a semi-unfolded state along with the housing assembly 10, as shown in FIG. 5.

Still referring to FIG. 6, in the housing assembly 10 of the foldable electronic device, both the first housing 10a and the second housing 10b may include the middle frame 100, and the first region 21 and the second region 22 of the display screen 20 may be supported on a front surface of the middle frame 100. For the outer foldable electronic device or the inner foldable electronic device on which the second display screen 20b is not additionally arranged, both the first housing 10a and the second housing 10b of the electronic device 1 may further include the rear cover 200, and the rear cover 200 is connected to a side surface of the middle frame 100 facing away from the display screen 20; and for the inner foldable electronic device on which the second display screen 20b is additionally arranged, one of the first housing 10a and the second housing 10b may not include the rear cover 200, and the second display screen 20b is mounted on a back surface of the middle frame 100 as an alternative.

In the first housing 10a and the second housing 10b, the middle frame 100 and the rear cover 200 (the second display screen 20b) jointly define an accommodating cavity, and the accommodating cavity is configured to mount devices such as a circuit board (not shown in the figure), a battery (not shown in the figure), an interface device (not shown in the figure), a camera module (not shown in the figure), or a microphone (not shown in the figure). The middle frame 100 may include a middle plate portion 110 and a side frame portion 120, the display screen 20 is attached to the middle plate portion 110 as a whole, the side frame portion 120 is arranged around a periphery of the middle plate portion 110, and the rear cover 200 (the second display screen 20b) is adhered to the side frame portion 120.

For the straight plate electronic device or the foldable electronic device, as the lightening and thinning trend of the electronic device 1, designs of some structures of the housing assembly 10 of the electronic device 1 have become a bottleneck in reducing an entire thickness. Especially, in application of the foldable electronic device, the housing assembly 10 cannot be further thinned, and as a result, the entire thickness (especially in the folded state) is large.

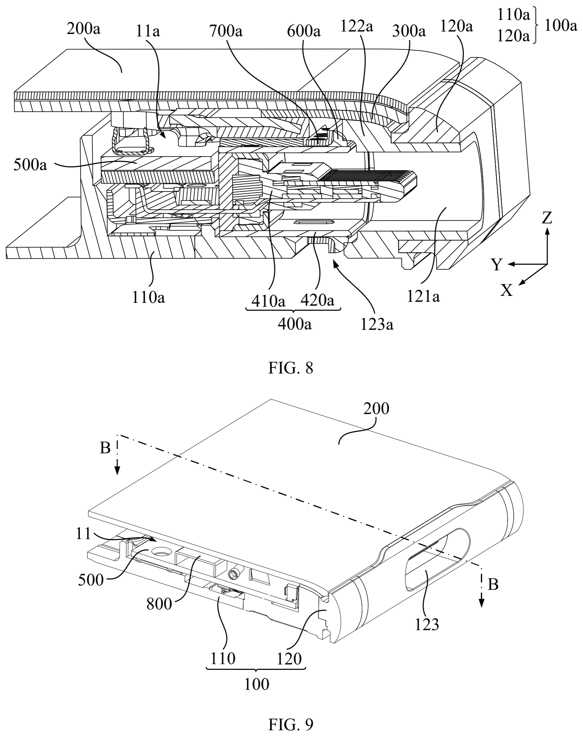

FIG. 7 is a partial structural diagram of a housing assembly in the related art; and FIG. 8 is a cross-sectional view of the housing assembly in FIG. 7 along A-A. Referring to FIG. 7 and FIG. 8, a middle plate portion 110a of a middle frame 100a is located on a side of a side frame portion 120a facing away from a rear cover 200a, and a gap between the middle plate portion 110a and the rear cover 200a forms an accommodating cavity 11a. A partial structure of a part in which an insertion hole 121a provided on the middle frame 100a is located is shown in the figures, the insertion hole 121a is provided on the side frame portion 120a of the middle frame 100a, and the insertion hole 121a extends inward to be in communication with the accommodating cavity 11a.

The insertion hole 121a is configured to mount an interface device 400a, the interface device 400a may be a USB (Universal Serial Bus, universal serial bus) interface, the interface device 400a is connected to a circuit board 500a arranged in the accommodating cavity 11a, and the interface device 400a is configured to connect to an external device. For example, a data line is inserted into the insertion hole 121a to implement a connection between the interface device 400a and the external device such as an external power supply, a headset, or a storage device, to charge the electronic device or implement interaction between the electronic device and the external device.

The rear cover 200a is adhered to the side frame portion 120a of the middle frame 100a through a back adhesive layer 300a, and the back adhesive layer 300a is arranged surrounding the side frame portion, where the back adhesive layer 300a passes through the part in which the insertion hole 121a is located. For a standard device like the interface device 400a, a requirement is also proposed for a size of the insertion hole 121a, and a size of the middle frame 100a is therefore limited. That is, a size of the side frame portion 120a of the middle frame 100a in a thickness direction (a direction Z in FIG. 8) of the electronic device is limited, and a wall thickness of the side frame portion 120a of the middle frame 100a at the part in which the insertion hole 121a is located (the side facing the rear cover 200a) should meet a structural strength requirement of the middle frame 100a.

Limited by the wall thickness of the side frame portion 120a at the part in which the insertion hole 121a is located, in the related art, the back adhesive layer 300a stacked on the side frame portion 120a is far away from the interface device 400a. The side frame portion 120a (the side facing the rear cover 200a) includes a bottleneck portion 122a in a region in which the insertion hole 121a is located, and the bottleneck portion 122a is located at a standard-size segment of the insertion hole 121a, where the standard-size segment of the insertion hole 121a is a hole segment on which a width of the insertion hole 121a (in the direction Z in FIG. 8) needs to meet a design requirement and cannot be reduced. The back adhesive layer 300a covers a bottleneck region of the side frame portion 120a, so that the adhesive layer is far away from the interface device 400a.

Based on this, the rear cover 200a is further stacked on the back adhesive layer 300a. For the back adhesive layer 300a covering the bottleneck region of the side frame portion 120a, the back adhesive layer 300a independently occupies a space between the side frame portion 120a of the middle frame 100a and the rear cover 200a, and in the thickness direction of the electronic device 1, the rear cover 200a is arranged at a position that is outer than (closer to a back surface of the electronic device 1) the side frame portion 120a of the middle frame 100a, and a gap between the rear cover 200a and the middle frame 100a cannot be further narrowed. As a result, the entire thickness of the electronic device cannot be reduced.

Still referring to FIG. 8, in addition to a device body 410a, the interface device 400a in the related art generally further includes an outer frame 420a, where the outer frame 420a is arranged around an outer periphery of the device body 410a and the outer frame 420a is attached to an inner wall surface of the insertion hole 121a, and a space between the outer frame 420a and the device body 410a should meet a design requirement, to implement a connection between the interface device 400a and the external device. Therefore, no matter for a case that a hole wall of the insertion hole 121a is a smooth wall surface and a wall thickness of the outer frame 420a is totally located in a region defined by the insertion hole 121a (the outer frame 420a independently occupies a space in the insertion hole 121a) or a case that a shallow groove is formed on the hole wall of the insertion hole 121a and the outer frame 420a is partially embedded into the hole wall of the insertion hole 121a (a partial wall thickness of the outer frame 420a occupies a space in which the hole wall of the insertion hole 121a is located), a size of the insertion hole 121a in the thickness direction of the electronic device (the direction Z in FIG. 8) is expanded to a certain extent. As a result, a gap between a side wall of a side of the side frame portion 120a of the middle frame 100a facing the rear cover 200a and the middle plate portion 110a becomes larger, which is not conducive to reducing the entire thickness of the electronic device.

Since the outer frame 420a is arranged around the outer periphery of the device body 410a, when the insertion hole 121a on the side frame portion 120a is sealed, a sealing ring 600a is generally sleeved on an outer wall surface of the outer frame 420a. For example, the sealing ring 600a is adhered to the outer wall surface of the outer frame 420, and the sealing ring 600a is in close contact with the side frame portion 120a, so that the sealing ring 600a is squeezed to seal the insertion hole 121a and prevent external foreign objects such as moisture or dust from entering the accommodating cavity 11a from a seam between the interface device 400a and the insertion hole 121a.

For a case that the outer frame 420a is attached to an inner wall of the insertion hole 121a, an avoidance groove 123a is provided at a part on the side frame portion 120a corresponding to the outer frame 420a, the sealing ring 600a is arranged in the avoidance groove 123a, one side of the sealing ring 600a is fixed by a support 700a fixed to the outer wall surface of the outer frame 420, another side of the sealing ring 600a is in close contact with a groove wall of the avoidance groove 123a, and the sealing ring 600a is squeezed between the support 700a and the groove wall of the avoidance groove 123a, to seal a gap between the outer frame 420 and the insertion hole 121a.

In view of this, a connection structure between the rear cover and the middle frame is improved in this embodiment, an engagement portion is arranged on the side of the middle frame facing the rear cover, so that the engagement portion avoids a bottleneck portion of the middle frame, and the engagement portion is recessed toward the side facing away from the rear cover. By using the engagement portion as a carrying basis of an adhesive layer, the adhesive layer between the middle frame and the rear cover passes through a region in which the engagement portion is located. In this way, the adhesive layer is carried by arranging the recessed engagement portion on the middle frame while the bottleneck portion of the middle frame is avoided to ensure a structural strength of the middle frame, so that the adhesive layer no longer occupies a thickness space of the electronic device alone, but the adhesive layer can be accommodated through at least a part of a wall thickness space of the middle frame. Therefore, the gap between the rear cover and the middle frame is reduced, and the entire thickness is reduced while a waterproof effect of the electronic device is ensured, which is conducive to the lightening and thinning development of the electronic device.

The housing assembly 10 of the electronic device 1 in this embodiment is described below in detail with reference to the accompanying drawings.

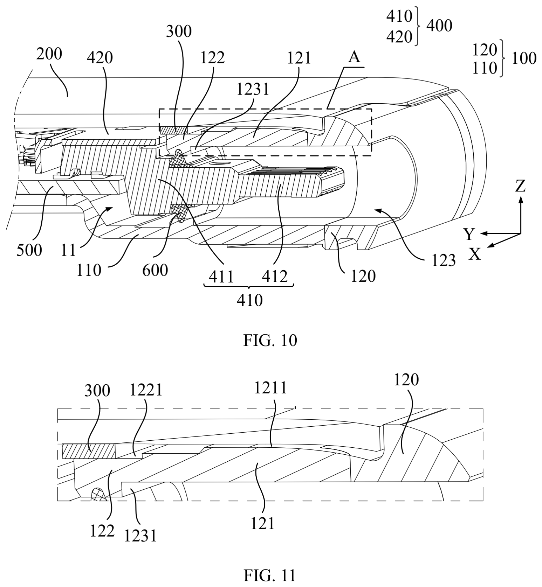

FIG. 9 is a partial structural diagram of a housing assembly according to an embodiment of this application; and FIG. 10 is a cross-sectional view of the housing assembly in FIG. 9 along B-B. Referring to FIG. 9 and FIG. 10, a partial structure of a part of the housing assembly 10 on the middle frame 100 and in which the insertion hole 123 is located is shown in the figures. No matter the electronic device 1 is a straight plate electronic device or a foldable electronic device, in this embodiment, the housing assembly 10 of the electronic device 1 includes the middle frame 100 and the rear cover 200, where the middle plate portion 110 of the middle frame 100 is connected to the side of the side frame portion 120 facing away from the rear cover 200, the side frame portion 120 of the middle frame 100 is adhered to the rear cover 200 through an adhesive layer 300, and the middle plate portion 110, the side frame portion 120, and the rear cover 200 jointly define an accommodating cavity 11.

The adhesive layer 300 may be a solid thin film layer, and an initial state of the adhesive layer 300 may be a solid thin film. Before the middle frame 100 and the rear cover 200 are connected, the adhesive layer 300 is first adhered to the middle frame 100 or the rear cover 200, the middle frame 100 and the rear cover 200 are then attached to each other, and the adhesive layer 300 is adhered between the middle frame 100 and the rear cover 200 through pressure. Alternatively, the adhesive layer 300 may be a liquid curing surface, and an initial state of the adhesive layer 300 may be liquid glue before being cured and formed. The liquid glue may be sprayed on the middle frame 100 or the rear cover 200 through a glue dispensing process, the middle frame 100 and the rear cover 200 are then attached to each other, and a solid adhesive layer 300 is formed after the liquid glue is cured and stably and reliably connected between the middle frame 100 and the rear cover 200.

A circuit board 500 arranged in the accommodating cavity 11 is shown in the figure, and the circuit board 500 is arranged close to the insertion hole 123. That is, the circuit board 500 is arranged close to the side frame portion 120 of the middle frame 100. For example, the circuit board 500 arranged in the accommodating cavity 11 of the electronic device 1 may include a main circuit board (referred to as a motherboard for short) and an auxiliary circuit board (referred to as a secondary board for short), and the main circuit board and the auxiliary circuit board may be electrically connected to each other. Devices such as A system on chip (System-on-a-chip, SOC), a memory, a radio frequency device, and a power supply chip may be arranged on the motherboard, the secondary board may be arranged close to the side frame portion 120 of the middle frame 100, and the secondary board is configured to carry devices that need to be arranged close to the side frame portion 120 or devices that cannot be integrated on the motherboard. For example, devices such as a microphone, a speaker, the interface device 400, and an elastic sheet may be arranged on the secondary board. In view of this, the circuit board 500 shown in the figure may be a secondary board.

The interface device 400 is mounted in the insertion hole 123 opened on the side frame portion 120 of the middle frame 100, and the interface device 400 may be the USB interface described above. For example, the interface device 400 is a Type-C interface or a Micro USB interface, and the interface device 400 is connected to the circuit board 500 (for example, a secondary board) close to the side frame portion 120 in the accommodating cavity 11. For example, the interface device 400 may be connected to a pad on the circuit board 500 through a pin. During actual application, the interface device 400 may be connected to an external device such as an external power supply, a headset, or a storage device by inserting a data line matching the interface device 400 into the insertion hole 123.

As described above, for a standard device like the interface device 400, correspondingly, there is a fixed requirement for a size of the insertion hole 123. At a part in which the insertion hole 123 is located on the side frame portion 120 of the middle frame 100, a side hole wall of the insertion hole 123 facing the rear cover 200 forms a wall thickness of the side frame portion 120 at the part, and in a case that the size of the insertion hole 123 is fixed, the wall thickness of the side hole wall of the insertion hole 123 facing the rear cover 200 needs to be ensured, to meet a structural strength requirement of the side frame portion 120 of the middle frame 100.

In view of this, the side hole wall of the insertion hole 123 facing the rear cover 200 generally includes a bottleneck portion 121, and the bottleneck portion 121 exists since the part needs to meet a dimension of the insertion hole 123 in the thickness direction of the electronic device 1 (the direction Z shown in FIG. 10). In addition, the part further needs to meet the structural strength requirement of the side frame portion 120 of the middle frame 100, so that a gap between the bottleneck portion 121 on the side hole wall of the insertion hole 123 and the interface device 400 cannot be narrowed, and a wall thickness of the bottleneck portion 121 cannot be excessively reduced.

In other words, in this embodiment, a gap meeting a requirement needs to be kept between an inner wall surface of the bottleneck portion 121 of the insertion hole 123 and a surface of a corresponding side of the interface device 400, to meet a use requirement of the insertion hole 123. In addition, the wall thickness of the bottleneck portion 121 needs to be greater than or equal to a preset thickness, where the preset thickness is a minimum thickness meeting a design requirement, to ensure a sufficient wall thickness of the part in which the insertion hole 123 is located and ensure a structural strength of the side frame portion 120 at the part in which the insertion hole 123 is located.

Referring to FIG. 10, to narrow a gap between the rear cover 200 and the side frame portion 120 of the middle frame 100, in this embodiment, an engagement portion 122 is designed in a region avoiding the bottleneck portion 121 on the side hole wall of the insertion hole 123 facing the rear cover 200. That is, the engagement portion 122 is a portion on the side frame portion 120 of the middle frame 100 and on which the adhesive layer 300 is arranged. In other words, a segment of the adhesive layer 300 passing through the insertion hole 123 on the side frame portion 120 is located on the engagement portion 122. Compared with the bottleneck portion 121, the engagement portion 122 is recessed toward a side facing away from the rear cover 200, and in a thickness direction of the housing assembly 10 (the direction Z shown in the figure), a side surface of the engagement portion 122 facing the rear cover 200 is located between an inner wall surface of the insertion hole 123 and a side surface of the bottleneck portion 121 facing the rear cover 200.

In this embodiment, the engagement portion 122 is arranged on the side hole wall of the insertion hole 123 facing the rear cover 200, so that the engagement portion 122 is recessed at the bottleneck portion 121 of the insertion hole 123 on the side hole wall, and a segment of the adhesive layer 300 corresponding to the insertion hole 123 is connected to the engagement portion 122. In this way, the adhesive layer 300 avoids the bottleneck portion 121 of the insertion hole 123, the recessed engagement portion 122 may provide more space for arranging the adhesive layer 300, and the adhesive layer 300 at least partially occupies a wall thickness of the side frame portion 120 of the middle frame 100. That is, the adhesive layer 300 may reuse a space of the side frame portion 120 in the thickness direction of the electronic device 1 (the direction Z shown in FIG. 10), to reduce a thickness space of the electronic device 1 occupied by the adhesive layer 300 and narrow the gap between the rear cover 200 and the side frame portion 120, so as to reduce the entire thickness of the electronic device 1.

In addition, the engagement portion 122 avoids a region in which the bottleneck portion 121 is located, so that the engagement portion 122 does not affect the segment of the insertion hole 123 that needs to keep the size meeting the requirement, and a requirement of a connection between the insertion hole 123 and the external device can be ensured. Based on this, a structural strength of the side frame portion 120 at a part in which the side hole wall of the insertion hole 123 facing the rear cover 200 is located is mainly determined by the bottleneck portion 121, so that the recessed engagement portion 122 does not affect the structural strength of the side frame portion 120 neither.

In conclusion, in this embodiment, the recessed engagement portion 122 is designed in the region avoiding the bottleneck portion 121 on the side hole wall of the insertion hole 123 facing the rear cover 200 at the part of the side frame portion 120 of the middle frame 100 corresponding to the insertion hole 123, and the engagement portion 122 is used as a carrying portion of the adhesive layer 300, thereby reducing the entire thickness on the basis of ensuring a firm connection between the middle frame 100 and the rear cover 200 and a waterproof effect of the entire device. For example, the entire thickness may be reduced by 0.2 mm to 0.3 mm, which is conducive to the lightening and thinning development of the electronic device 1.

FIG. 11 is a partial enlarged view of the housing assembly in FIG. 10 at a position A. Referring to FIG. 11, for ease of description, in this embodiment, on the side hole wall of the insertion hole 123 facing the rear cover 200, the side surface of the bottleneck portion 121 facing the rear cover 200 is defined as a first positioning surface 1211, the side surface of the engagement portion 122 facing the rear cover 200 is defined as a second positioning surface 1221, the second positioning surface 1221 is recessed in the first positioning surface 1211, the second positioning surface 1221 faces away from the rear cover 200 relative to the first positioning surface 1211, and a space for arranging the adhesive layer 300 exists between a plane in which the second positioning surface 1221 is located and a plane in which the first positioning surface 1211 is located. Therefore, the adhesive layer 300 reuses the space of the side frame portion 120 in the thickness direction of the electronic device 1, and the adhesive layer 300 at least partially occupies the wall thickness of the side frame portion 120, so that a thickness of the adhesive layer 300 protruding from the first positioning surface 1211 is reduced, the adhesive layer 300 is even totally located in a wall thickness space of the side frame portion 120, and the adhesive layer 300 is flush with the first positioning surface 1211 or is recessed in the first positioning surface 1211.

In some implementations, a gap between the second positioning surface 1221 of the engagement portion 122 and the first positioning surface 1211 of the bottleneck portion 121 is greater than or equal to 1/2 of a thickness of the adhesive layer 300. That is, at least 1/2 of the thickness of the adhesive layer 300 is located in a thickness space of the side frame portion 120 of the middle frame 100, and a part of the adhesive layer 300 protruding from the side frame portion 120 is less than 1/2 of the thickness of the adhesive layer. Therefore, compared with a case that the adhesive layer 300 independently occupies the thickness space of the electronic device 1 in the related art, in this embodiment, the engagement portion 122 is designed to carry the adhesive layer 300, so that the gap between the rear cover 200 and the side frame portion 120 of the middle frame 100 may be reduced to at least 1/2 of the thickness of the adhesive layer 300.

For example, the gap between the second positioning surface 1221 of the engagement portion 122 and the first positioning surface 1211 of the bottleneck portion 121 may be greater than or equal to 2/3, 3/4, or 4/5 of the thickness of the adhesive layer 300.

It should be noted that, the gap between the second positioning surface 1221 of the engagement portion 122 and the first positioning surface 1211 of the bottleneck portion 121 should be less than or equal to the thickness of the adhesive layer 300. In other words, a maximum value of the gap between the second positioning surface 1221 and the first positioning surface 1211 is the thickness of the adhesive layer 300. When the gap between the second positioning surface 1221 and the first positioning surface 1211 is the thickness of the adhesive layer 300 and the rear cover 200 is adhered to the side frame portion 120 of the middle frame 100, the rear cover 200 exactly abuts against the bottleneck portion 121 of the side frame portion 120.

Still referring to FIG. 10, the part in which the insertion hole 123 is located on the middle frame 100 is still used as an example, for the insertion hole 123 provided for insertion of devices such as a data line, a segment having a size requirement of the insertion hole 123 generally extends in a direction from an outer wall surface of the side frame portion 120 toward the middle plate portion 110, so that in the side hole wall of the insertion hole 123 facing the rear cover 200, the bottleneck portion 121 may be located in an edge region of the middle frame 100, and the engagement portion 122 is located on a side of the bottleneck portion 121 facing away from an edge of the middle frame 100. That is, the bottleneck portion 121 extends inward from the outer wall surface of the side frame portion 120, and the engagement portion 122 may be located on a side of the bottleneck portion 121 facing away from the outer wall surface of the side frame portion 120.

Based on this, the engagement portion 122 may be adjacent to the bottleneck portion 121. In this way, in a case that the side frame portion 120 has a limited space, a region adjacent to the bottleneck portion 121 is also enough to arrange the engagement portion 122. In addition, the engagement portion 122 is still kept in a region close to the edge of the middle frame 100, so that the adhesive layer 300 connected to the engagement portion 122 can firmly connect the rear cover 200 and the middle frame 100, thereby ensuring a connection strength between the rear cover 200 and the middle frame 100 and ensuring a waterproof effect of the electronic device 1.

For example, the engagement portion 122 is located in an edge region of the side hole wall of the insertion hole 123 facing the rear cover 200. In other words, the engagement portion 122 may be located in an edge region of a side of the side frame portion 120 extending to the accommodating cavity 11, the engagement portion 122 extends to the accommodating cavity 11, and a side of the engagement portion 122 facing the accommodating cavity 11 may be in communication with the accommodating cavity 11. For the engagement portion 122 configured to carry the adhesive layer 300, a region in which the engagement portion 122 is located may be processed into a plate-shaped structure for ease of adhering the adhesive layer 300 between the engagement portion 122 and the rear cover 200, and the engagement portion 122 is arranged at an edge of the side frame portion 120 and extends to be in communication with the accommodating cavity 11 for ease of processing of the side frame portion 120, so that the engagement portion 122 may be formed by forming a plane recessed in a top surface at an edge of the side frame portion 120 extending to the accommodating cavity 11.

Still referring to FIG. 10, the interface device 400 includes a device body 410, and the device body 410 may include a power connection end 411 and an insertion end 412 connected sequentially in a direction from the accommodating cavity 11 to the insertion hole 123 (an opposite direction of a direction Y shown in the figure). The power connection end 411 of the device body 410 extends into the accommodating cavity 11 to be connected to the circuit board 500 (for example, a secondary board). For example, a pin of the device body 410 extends out from the power connection end 411 and is connected to a pad on the circuit board 500, to implement a connection between the device body 410 and the circuit board 500. The insertion end 412 of the device body 410 is located in the insertion hole 123, the insertion end 412 extends in the insertion hole 123 to the outside of the electronic device 1, and the device body 410 is connected to an external device through the insertion end 412. For example, a data line extends into the insertion hole 123 and is inserted into the insertion end 412 of the device body 410, to implement a connection between the device body 410 and the external device through the data line.

A corresponding region in the insertion hole 123 and in which the insertion end 412 of the device body 410 is located needs to be connected to the external device, so that the region of the insertion hole 123 has a size requirement, and in the side hole wall of the insertion hole 123 facing the rear cover 200, a portion corresponding to the region in which the insertion end 412 of the device body 410 is located is the bottleneck portion 121. Therefore, when the engagement portion 122 is designed on the side hole wall of the insertion hole 123, the engagement portion 122 may correspond to a region in which a connection portion between the insertion end 412 and the power connection end 411 of the device body 410 is located, or the engagement portion 122 may correspond to the region in which the power connection end 411 is located, so that the engagement portion 122 avoids the bottleneck portion 121.

For example, in a case that a width (a dimension in the direction Y in the figure) of the side frame portion 120 of the middle frame 100 is limited, the power connection end 411 of the device body 410 may be totally located in the accommodating cavity 11, and the insertion hole 123 is mainly configured to accommodate the insertion end 412 of the device body 410. In this case, the connection portion between the power connection end 411 and the insertion end 412 of the device body 410 is located at the edge of the side frame portion 120 facing the accommodating cavity 11. That is, the engagement portion 122 may be located in the edge region of the side frame portion 120 facing the accommodating cavity 11, and the engagement portion 122 may correspond to the connection portion between the insertion end 412 and the power connection end 411 of the device body 410.

In addition, still referring to FIG. 10, compared with the interface device 400a (referring to FIG. 8) in the related art, in the interface device 400 in this embodiment, the outer frame 420a is omitted. In other words, the device body 410 of the interface device 400 directly passes through the insertion hole 123, the outer frame 420a is not arranged around an outer periphery of the device body 410, an insertion cavity is defined between an outer wall surface of the insertion end 412 of the device body 410 and a hole wall of the insertion hole 123, and a connection between the device body 410 and the external device is implemented through the insertion cavity. For example, a data line is inserted into the insertion cavity to be connected to the device body 410.

Without limitation of the outer frame, an outer wall surface of the device body 410 and the hole wall of the insertion hole 123 directly define the insertion cavity, and there is no need to expand a size of the insertion hole 123 to arrange the outer frame provided that a hole opening size of the insertion hole 123 meets a connection requirement of being connected to the external device. Further, there is also no need to increase a dimension of the side frame portion 120 of the middle frame 100 in the thickness direction of the electronic device 1 (the direction Z in FIG. 10), so that the middle frame 100 may keep a small thickness, which is conducive to reducing the entire thickness of the electronic device 1.

In addition, no outer frame is arranged around the outer periphery of the device body 410, so that a seam in communication with the accommodating cavity 11 is formed between the outer wall surface of the device body 410 and the hole wall of the insertion hole 123. Therefore, when the insertion hole 123 is sealed, a sealing member 600 may be arranged on the outer wall surface of the device body 410, and the sealing member 600 is in close contact with the hole wall of the insertion hole 123, to seal the insertion hole 123 and prevent external foreign objects such as moisture or dust from entering the accommodating cavity 11 from the seam between the insertion hole 123 and the device body 410, thereby ensuring a waterproof effect of the entire electronic device 1.

It should be understood that the sealing member 600 should avoid the insertion end 412 of the device body 410 to prevent a connection between the insertion end 412 and the external device from being affected. For example, for a case that the power connection end 411 of the device body 410 is totally located in the accommodating cavity 11, the sealing member 600 may be sleeved on the connection portion between the power connection end 411 and the insertion end 412 of the device body 410. An example in which the engagement portion 122 corresponds to the connection portion between the power connection end 411 and the insertion end 412 of the device body 410 is used, the sealing member 600 may be arranged corresponding to the engagement portion 122.

For example, the sealing member 600 may be an independently formed sealing ring. For example, the sealing member 600 is a silicone ring or a rubber ring. Alternatively, the sealing member 600 may be a sealing layer integrally formed on a surface of the device body 410, and a layer of sealing layer may be formed on the surface of the device body 410 through an injection molding process. For example, the sealing member 600 may be a silicone layer or a rubber layer.

For ease of close contact between the sealing member 600 and the hole wall of the insertion hole 123, still referring to FIG. 10, in some implementations, the hole wall of the insertion hole 123 protrudes inward to form a positioning boss 1231, the positioning boss 1231 may be a protruding annular boss on the hole wall of the insertion hole 123, and the positioning boss 1231 corresponds to the sealing member 600. The positioning boss 1231 is used to reduce a gap between the insertion hole 123 at the portion and the device body 410, and it is ensured that the positioning boss 1231 may be in close contact with the sealing member 600 and squeeze the sealing member 600, thereby further ensuring a sealing effect of the sealing member 600.

The positioning boss 1231 should avoid the bottleneck portion 121 of the insertion hole 123. For example, the positioning boss 1231 may be arranged corresponding to the engagement portion 122. In other words, the positioning boss 1231 is located in the region in which the engagement portion 122 is located. On one hand, it may be ensured that the positioning boss 1231 avoids the bottleneck portion 121 of the insertion hole 123, so that the connection between the interface device 400 and the external device is not affected. On the other hand, since the positioning boss 1231 protrudes on an inner wall of the insertion hole 123, a thickness of the region in which the recessed engagement portion 122 is located may be increased, and a structural strength of the region in which the engagement portion 122 is located may be improved.

For example, the engagement portion 122 may be located in a region in which the connection portion between the insertion end 412 and the power connection end 411 of the device body 410 is located, the sealing member 600 is sleeved on the portion between the insertion end 412 and the power connection end 411 of the device body 410, the positioning boss 1231 is arranged corresponding to the sealing member 600, and the positioning boss 1231 protrudes on a side of the engagement portion 122 facing the insertion hole 123.

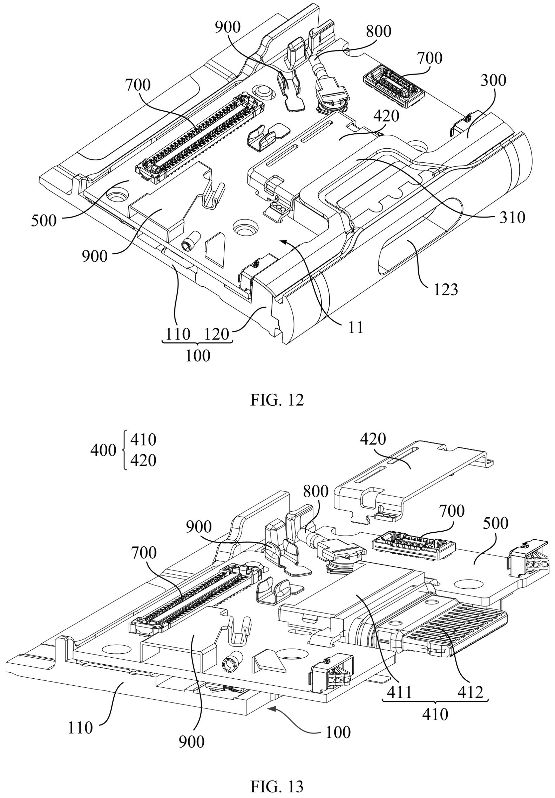

FIG. 12 is a schematic structural diagram of the housing assembly in FIG. 9 with a rear cover removed. Referring to FIG. 12, a shape of a structure of the adhesive layer 300 located between the side frame portion 120 of the middle frame 100 and the rear cover 200 at the part in which the insertion hole 123 is located is shown in the figure. The side frame portion 120 extends inward from an outer edge of the side frame portion 120 at the bottleneck portion 121 of the region in which the insertion hole 123 is located, and the engagement portion 122 is located on a side of the side frame portion 120 close to the accommodating cavity 11. Therefore, the adhesive layer 300 protrudes toward the accommodating cavity 11 from the edge of the side frame portion 120 at the part in which the insertion hole 123 is located, the adhesive layer 300 forms a recessed segment 310 in this region, and the recessed segment 310 is recessed from the outer edge of the side frame portion 120. In other words, the recessed segment 310 protrudes toward the accommodating cavity 11.

For a shape of the recessed segment 310, an example in which the recessed segment 310 is approximately "U-shaped" is used in the figure. In other examples, the shape of the recessed segment 310 may alternatively be an arc, a semi-circle, or a trapezoid, which is not specifically limited in this embodiment.

FIG. 13 is an exploded structural view of the housing assembly 10 in FIG. 12. As shown in FIG. 12 and FIG. 13, in this embodiment, in addition to the device body 410, the interface device 400 further includes a fixing frame 420, where the fixing frame 420 is sleeved on the device body 410 and specifically may be sleeved on the power connection end 411 of the device body 410. For example, the fixing frame 420 may be adhered to an outer wall surface of the power connection end 411. The fixing frame 420 is connected to the circuit board 500 to position the device body 410, and the power connection end 411 of the device body 410 is fixed on a board surface of the circuit board 500 to ensure a firm connection between the power connection end 411 of the device body 410 and the circuit board 500 and position the insertion end 412 of the device body 410.

Referring to FIG. 12 or FIG. 13, in addition to the interface device 400, another device is further arranged on the circuit board 500 (for example, a secondary board) that is in the accommodating cavity 11 and close to the side frame portion 120. For example, devices such as a BTB (Board-to-board, board-to-board) connector, a coaxial cable 800, and an elastic sheet 900 may be further arranged on the circuit board 500. The BTB connector 700 is configured to implement a connection between the circuit board 500 and another component in the accommodating cavity 11. For example, the circuit board 500 is connected to another circuit board (for example, a motherboard) through the BTB connector 700. The coaxial cable 800 may be, for example, connected between the circuit board 500 (for example, a secondary board) and the another circuit board (for example, a motherboard) to transmit signals therebetween. The elastic sheet 900 is configured to clamp and fix some devices on the circuit board 500.

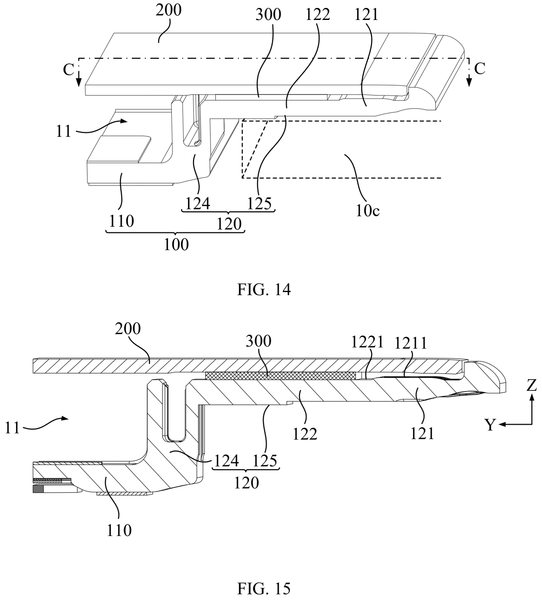

FIG. 14 is a partial structural diagram of another housing assembly according to an embodiment of this application; and FIG. 15 is a cross-sectional view of the housing assembly in FIG. 14 along C-C. Referring to FIG. 14 and FIG. 15, a partial structure of a housing assembly 10 of a foldable electronic device near a rotating shaft 10c is shown in the figure. In addition, a first housing 10a or a second housing 10b on a single side of the rotating shaft 10c is used as an example. It should be understood that, structures of the first housing 10a and the second housing 10b may be symmetrical, and structures of a connection portion between the first housing 10a and the rotating shaft 10c and a connection portion between the second housing 10b and the rotating shaft 10c may be consistent.

The first housing 10a and the second housing 10b may each include a middle frame 100 and a rear cover 200 (referring to FIG. 6). For an inner foldable electronic device, the rear cover 200 of the first housing 10a or the second housing 10b may alternatively be replaced with the second display screen 20b, and description is provided by using the rear cover 200 as an example hereinafter. The middle frame 100 may include a middle plate portion 110 and a side frame portion 120, where the middle plate portion 110 is connected to a side of the side frame portion 120 facing away from the rear cover 200, the side frame portion 120 is adhered to the rear cover 200 through an adhesive layer 300, and the middle plate portion 110, the side frame portion 120, and the rear cover 200 jointly define an accommodating cavity 11. The adhesive layer 300 may be the solid thin film layer or the liquid curing surface described above.

Referring to FIG. 14, a side of the side frame portion 120 of the middle frame 100 connected to the rotating shaft 10c generally includes a side wall 124 and an extending wall 125 sequentially connected to the middle plate portion 110. The side wall 124 extends from the middle plate portion 110 to the rear cover 200, and for example, the side wall 124 extends to the rear cover 200 in a direction perpendicular to the middle plate portion 110. The extending wall 125 extends in a plane direction of the rear cover 200, and the extending wall 125 extends to an edge of the rear cover 200. An edge region of the rear cover 200 is supported on the extending wall 125 of the side frame portion 120, and the side wall 124 of the side frame portion 120, the middle plate portion 110, and the rear cover 200 jointly define the accommodating cavity 11.

The middle frame 100 is connected to the rotating shaft 10c through the extending wall 125 of the side frame portion 120, and since a requirement of being connected to the rotating shaft 10c, the extending wall 125 of the side frame portion 120 generally also includes a bottleneck portion 121. The bottleneck portion 121 exists since the portion needs to be connected to the rotating shaft 10c, a gap between the bottleneck portion 121 and a front surface of the middle plate portion 110 (a side surface of the middle plate portion 110 facing away from the rear cover 200) needs to meet a connection space requirement of the rotating shaft 10c, and a wall thickness of the bottleneck portion 121 further needs to meet a structural strength requirement, to ensure a firm connection between the middle frame 100 and the rotating shaft 10c.

Therefore, a sufficient gap should be kept between the bottleneck portion 121 and the front surface of the middle plate portion 110, to meet a mounting space requirement of the rotating shaft 10c. In addition, the bottleneck portion 121 should have a sufficient wall thickness, and the wall thickness of the bottleneck portion 121 should be greater than or equal to a preset thickness, where the preset thickness is a minimum thickness meeting a design requirement, to ensure a sufficient strength of the extending wall 125 and ensure the stability and reliability of a connection between the middle frame 100 and the rotating shaft 10c.

Similar to the arrangement of the engagement portion 122 on the side hole wall of the insertion hole 123 facing the rear cover 200, referring to FIG. 14 or FIG. 15, to narrow a gap between the rear cover 200 and the side frame portion 120 of the middle frame 100, in this embodiment, an engagement portion 122 is designed in a region avoiding the bottleneck portion 121 on the extending wall 125 of the side frame portion 120, to carry the adhesive layer 300 through the engagement portion 122. That is, a segment of the adhesive layer 300 passing through the side frame portion 120 (a side facing the rotating shaft 10c) is located on the engagement portion 122. Compared with the bottleneck portion 121, the engagement portion 122 is recessed toward a side facing away from the rear cover 200, and a side surface of the engagement portion 122 facing the rear cover 200 is lower than a side surface of the bottleneck portion 121 facing the rear cover 200.

By arranging the engagement portion 122 recessed at the bottleneck portion 121, the adhesive layer 300 is connected to the engagement portion 122, and the adhesive layer 300 at least partially occupies a wall thickness of the extending wall 125 of the side frame portion 120. That is, the adhesive layer 300 may reuse a space of the extending wall 125 in the thickness direction of the electronic device 1 (the direction Z in FIG. 15), so that a thickness space occupied by the adhesive layer 300 is reduced, the gap between the rear cover 200 and the side frame portion 120 is narrowed, and the entire thickness of the electronic device 1 is further reduced.

In addition, since the engagement portion 122 avoids the bottleneck portion 121 on the extending wall 125 of the side frame portion 120, the engagement portion 122 does not affect a connection between the side frame portion 120 and the rotating shaft 10c, so that the bottleneck portion 121 keeps a wall thickness that the bottleneck portion should have, a structural strength of the extending wall 125 is not affected, and a stable and firm connection between the side frame portion 120 and the rotating shaft 10c may be ensured. Therefore, by arranging the engagement portion 122 on the extending wall 125 of the side frame portion 120 as a carrying portion of the adhesive layer 300, the entire thickness may be reduced on the basis of ensuring a firm connection between the middle frame 100 and the rear cover 200 through the adhesive layer 300 and a waterproof effect of the entire device. For example, the entire thickness may be reduced by 0.2 mm to 0.3 mm, which is conducive to the lightening and thinning development of the electronic device 1.

Referring to FIG. 15, similar to the part in which the insertion hole 123 is located on the side frame portion 120, for a foldable electronic device, in this embodiment, on the extending wall 125 of the side frame portion 120, a side surface of the bottleneck portion 121 facing the rear cover 200 is defined as a first positioning surface 1211, a side surface of the engagement portion 122 facing the rear cover 200 is defined as a second positioning surface 1221, the second positioning surface 1221 is recessed in the first positioning surface 1211, and the second positioning surface 1221 faces away from the rear cover 200 relative to the first positioning surface 1211, so that the adhesive layer 300 can reuse the space of the extending wall 125 in the thickness direction of the electronic device 1, and the adhesive layer 300 at least partially occupies the wall thickness of the extending wall 125. Therefore, a thickness of the adhesive layer 300 protruding from the first positioning surface 1211 is reduced, the adhesive layer 300 is even totally located in a wall thickness space of the extending wall 125, and the adhesive layer 300 is flush with the first positioning surface 1211 or is recessed in the first positioning surface 1211.

A gap between the second positioning surface 1221 of the engagement portion 122 and the first positioning surface 1211 of the bottleneck portion 121 should be less than or equal to a thickness of the adhesive layer 300. For example, the gap between the second positioning surface 1221 of the engagement portion 122 and the first positioning surface 1211 of the bottleneck portion 121 may be greater than or equal to 1/2 of the thickness of the adhesive layer 300. For example, the gap between the second positioning surface 1221 of the engagement portion 122 and the first positioning surface 1211 of the bottleneck portion 121 may be greater than or equal to 2/3, 3/4, or 4/5 of the thickness of the adhesive layer 300, and details are not described herein.

The rotating shaft 10c is connected between the middle frame 100 of the first housing 10a and the middle frame 100 of the second housing 10b, so that the bottleneck portion 121 on the extending wall 125 of the side frame portion 120 is generally located in an edge region, and the engagement portion 122 is located on a side of the bottleneck portion 121 facing away from an edge of the extending wall 125. Based on this, the engagement portion 122 may be adjacent to the bottleneck portion 121, and a side of the engagement portion 122 facing the accommodating cavity 11 may be in communication with the accommodating cavity 11. For example, a region in which the engagement portion 122 is located may be processed into a plate-shaped structure, and a plane in which the engagement portion 122 is located extends to a side of the side frame portion 120 in communication with the accommodating cavity 11. Details are not described herein.

In the description of the embodiments of this application, it should be noted that, unless otherwise explicitly specified and defined, the terms "mount", "connect", and "connection" should be understood in a broad sense. For example, the connection may be a fixed connection, an indirect connection through an intermediate medium, communication inside two elements, or an interactive relationship between two elements. A person of ordinary skill in the art may understand specific meanings of the foregoing terms in the embodiments of this application according to a specific situation.

In the specification, claims, and accompanying drawings of the embodiments of this application, the terms "first", "second", "third", "fourth", and so on (if existing) are intended to distinguish between similar objects but do not necessarily indicate a specific order or sequence.

## Claims

1. A housing assembly, comprising:
a rear cover;
a middle frame, comprising an engagement portion on a side facing the rear cover, wherein the engagement portion avoids a bottleneck portion of the middle frame, and the engagement portion is recessed toward a side facing away from the rear cover relative to the bottleneck portion; and
an adhesive layer, arranged between the rear cover and the middle frame and passing through a region in which the engagement portion is located.

2. The housing assembly according to claim 1, wherein the bottleneck portion is located in an edge region of the middle frame, and the engagement portion is adjacent to a side of the bottleneck portion facing away from an edge of the middle frame.

3. The housing assembly according to claim 2, wherein a side surface of the bottleneck portion facing the rear cover is a first positioning surface, a side surface of the engagement portion facing the rear cover is a second positioning surface, and a gap between the second positioning surface and the first positioning surface is greater than or equal to 1/2 of a thickness of the adhesive layer.

4. The housing assembly according to any one of claims 1 to 3, wherein the middle frame comprises a middle plate portion and a side frame portion, the side frame portion is arranged around a periphery of the middle plate portion, and the middle plate portion, the side frame portion, and the rear cover jointly define an accommodating cavity, wherein
both the engagement portion and the bottleneck portion are located on the side frame portion.

5. The housing assembly according to claim 4, wherein the housing assembly comprises a first housing and a second housing, and both the first housing and the second housing comprise the middle frame and the adhesive layer; and
the housing assembly further comprises:
a rotating shaft, connected between the middle frame of the first housing and the middle frame of the second housing, wherein both the engagement portion and the bottleneck portion are located in a region of the side frame portion corresponding to the rotating shaft.

6. The housing assembly according to claim 5, wherein the side frame portion comprises a side wall and an extending wall sequentially connected to the middle plate portion, the side wall extends to the rear cover, and the extending wall extends to an edge of the rear cover in a plane direction of the rear cover, wherein
the extending wall comprises the engagement portion and the bottleneck portion.

7. The housing assembly according to any one of claims 4 to 6, wherein the side frame portion is provided with an insertion hole, an interface device is mounted in the insertion hole, and the interface device is configured to connect to an external device, wherein
a side hole wall of the insertion hole facing the rear cover comprises the bottleneck portion and the engagement portion.

8. The housing assembly according to claim 7, wherein the interface device comprises a device body, the device body comprises a power connection end and an insertion end sequentially connected in a direction from the accommodating cavity to the insertion hole, the power connection end is connected to a circuit board arranged in the accommodating cavity, and the insertion end is configured to connect to the external device, wherein
the bottleneck portion corresponds to a region in which the insertion end is located; and the engagement portion corresponds to a region in which a connection portion between the insertion end and the power connection end is located, or the engagement portion corresponds to a region in which the power connection end is located.

9. The housing assembly according to claim 8, wherein an insertion cavity is defined between an outer wall surface of the insertion end and a hole wall of the insertion hole, and the insertion cavity is configured for insertion of the external device.

10. The housing assembly according to claim 9, wherein a sealing member is arranged on an outer wall surface of the device body, and the sealing member is in close contact with the hole wall of the insertion hole.

11. The housing assembly according to claim 10, wherein the hole wall of the insertion hole protrudes inward to form a positioning boss, and the sealing member is in close contact with the positioning boss.

12. The housing assembly according to claim 11, wherein the positioning boss is located in the region in which the engagement portion is located.

13. The housing assembly according to any one of claims 8 to 12, wherein the interface device further comprises a fixing frame, the fixing frame is sleeved on the device body, and the fixing frame is connected to the circuit board.

14. The housing assembly according to any one of claims 7 to 13, wherein the adhesive layer comprises a recessed segment protruding toward the accommodating cavity at a portion in which the insertion hole is located.

15. The housing assembly according to any one of claims 1 to 14, wherein the adhesive layer is a solid thin film layer or a liquid curing surface.

16. An electronic device, comprising a display screen and the housing assembly according to any one of claims 1 to 15, wherein the display screen is connected to the housing assembly.
